# EUROPÄISCHE PATENTSCHRIFT

(11) **EP 2 015 087 B1**
(45) Veröffentlichungstag und Bekanntmachung des Hinweises auf die Patenterteilung: **21.12.2011**
(21) Anmeldenummer: 08011535.5
(22) Anmeldetag: 25.06.2008
(51) Int. Cl.: G01R 31/28

(54) **Vorrichtung zum Testen von elektronischen Bauelementen, insbesondere IC's, mit innerhalb einer Drucktestkammer angeordnetem Abdichtboard**
Device for testing electronic components, in particular ICs, with a sealing board arranged within a pressure test chamber
Dispositif de test de composants électroniques, en particulier IC, doté d'une carte d'étanchéité installée à l'intérieur d'une chambre de test de la pression

(30) Priorität: 12.07.2007 DE 102007032557
(43) Veröffentlichungstag der Anmeldung: 14.01.2009
(73) Patentinhaber: Multitest elektronische Systeme GmbH, 83026 Rosenheim (DE)
(72) Erfinder: Schaule, Max, 87719 Mindelheim (DE); Kurz, Stefan, 83026 Rosenheim (DE); Nagy, Andreas, 81825 München (DE)
(74) Vertreter: Bauer, Friedrich

(56) Entgegenhaltungen:
- EP-A- 1 011 134
- EP-A- 1 186 903
- EP-A- 1 596 429
- WO-A-01/13130
- GB-A- 2 285 348
- US-A- 6 072 325
- US-B1- 6 812 718

## Beschreibung

Die Erfindung betrifft eine Vorrichtung zum Testen von elektronischen Bauelementen, insbesondere IC's unter bestimmten Druckbedingungen, gemäß dem Oberbegriff des Anspruchs 1.

Elektronische Bauelemente, wie beispielsweise MEMS (Micro-Electro-Mechanical-System), die zur Druckermittlung verwendet werden, werden üblicherweise nach ihrer Herstellung Drucktests unterworfen, um ihre ordnungsgemäße Funktion zu überprüfen oder deren Funktionskennlinie bei unterschiedlichen Temperaturen auszugleichen, d.h. zu kalibrieren. Hierzu ist es teilweise erforderlich, mehrere hundert Parameter zu bestimmen. Die Drucktests finden in Drucktestkammern statt, die aus zwei voneinander trennbaren Druckkammerhälften bestehen. Die zu testenden Bauelemente werden dabei in eine der Druckkammerhälften eingelegt, worauf diese Druckkammerhälfte dann gegen die andere Druckkammerhälfte gefahren wird, bis sie sich in dichter Anlage an dieser anderen Druckkammerhälfte befindet. Bei diesem Vorgang werden Kontakte der Bauelemente mit in die Kavität der Drucktestkammer hineinragenden Kontaktelementen verbunden, die zu einer elektronischen Testeinrichtung führen. Anschließend wird in der Kavität der Drucktestkammer derjenige Druck erzeugt, mit dem die Tests durchgeführt werden sollen. Nach Beendigung der Tests werden die Druckkammerhälften wieder auseinander gefahren, so dass die Bauelemente entnommen und entsprechend dem Testergebnis sortiert werden können. Das Zuführen der Bauelemente in die Kavität und das Entnehmen der Bauelemente aus der Kavität erfolgen dabei zweckmäßiger Weise mittels eines Handlers, d.h. eines Handhabungsautomaten, der das Be- und Entladen der Bauelemente mit hoher Geschwindigkeit durchführt.

Es ist bekannt, mehrere nebeneinander angeordnete Bauelemente gleichzeitig zu testen, wodurch das Testen der Bauelemente wesentlich beschleunigt werden kann. Beispielsweise können mehrere vereinzelte Bauelemente in spezielle Tabletts (trays) eingelegt und dann die Drucktestkammer mit dem gesamten Tablett beladen werden. Weiterhin sind elektronische Bauelemente üblich, die in einem streifenförmigen Verbund (Strip) vorliegen, bevor sie voneinander getrennt werden. Es ist bekannt, derartige Strips in die Drucktestkammer einzulegen und sämtliche Bauelemente der Strips gleichzeitig zu testen.

Bei Drucktests ist es wesentlich, dass der gewünschte Testdruck innerhalb der Kavität der Drucktestkammer auf möglichst schnelle Weise aufgebaut und während des Tests konstant beibehalten werden kann. Es ist daher erforderlich, die Kavität nach außen zuverlässig abzudichten. Die Abdichtung muss dabei häufig auch hohen Testdrücken von beispielsweise 20 bar oder mehr standhalten können. Weiterhin sollten die Drucktestkammern so aufgebaut sein, dass sie auf möglichst einfache Weise für unterschiedliche Bauelemente umrüstbar sind.

Aus der EP 1 186 903 A2 ist eine Vorrichtung gemäß dem Oberbegriff des Anspruchs 1 zum Testen von Wafern in einer Testkammer bekannt. Dort ist an der Außenseite einer Testkammerhälfte ein bauelementspezifisches Board angeordnet, das einerseits mit testkopfseitigen Kontakten und andererseits mit Kontaktelementen kontaktiert werden kann, welche die Testkammerhälfte durchdringen. Diese Testkammerhälfte wird dabei innenseitig von einer Basislage begrenzt, die aus einem leitenden Gummi besteht und eine federnd nachgiebige Basis für Kontaktabschnitte der Testkammerhälfte bildet, die auf den Wafer aufgesetzt werden.

Der Erfindung liegt die Aufgabe zugrunde, eine Vorrichtung zum Testen von elektronischen Bauelementen, insbesondere IC's, unter bestimmten Druckbedingungen zu schaffen, die möglichst einfach aufgebaut und auf einfache und kostengünstige Weise an unterschiedliche Bauelemente anpassbar ist sowie die gewünschten Druckbedingungen auf zuverlässige Weise aufrecht erhält.

Diese Aufgabe wird erfindungsgemäß durch eine Vorrichtung mit den Merkmalen des Anspruchs 1 gelöst. Vorteilhafte Ausführungsformen der Erfindung sind in den weiteren Ansprüchen beschrieben.

Erfindungsgemäß ist innerhalb der Kavität ist ein luftdurchlässiges Abdichtboard angeordnet, das sich quer über die Kontaktelemente erstreckt und randseitig zur zugeordneten Druckkammerhälfte hin abgedichtet ist, wobei die ersten Kontaktelementabschnitte auf einer Seite des Abdichtboards und die den ersten Kontaktelementabschnitten zugeordneten zweiten Kontaktelementabschnitte auf der gegenüberliegenden Seite des Abdichtboards angeordnet sind. Weiterhin sind die ersten Kontaktelementabschnitte mit den gegenüberliegenden zweiten Kontaktelementabschnitten über leitende Abschnitte des Abdichtboards elektrisch verbunden. Das bauelementspezifische DUT-Board ist innerhalb der Kavität zwischen den zweiten Kontaktelementabschnitten und zu den zweiten Kontaktelementabschnitten beabstandetem dritten Kontaktelementabschnitte angeordnet, mit denen die Kontakte der Bauelemente in Kontakt bringbar sind.

Bei der erfindungsgemäßen Vorrichtung ist es somit nicht erforderlich, die ersten Kontaktelementabschnitte, welche die Drucktestkammer durchdringen und sich von der Kavität nach außen erstrecken, einzeln abzudichten. Vielmehr werden sämtliche erste Kontaktelementabschnitte durch das Abdichtboard gemeinsam abgedichtet. Auf der gegenüberliegenden Seite des Abdichtboards sind dann die zweiten Kontaktelementabschnitte befestigt, die - getrennt durch das Abdichtboard - sich bereits in demjenigen Bereich der Kavität befinden, in dem der gewünschte Testdruck aufgebaut wird.

Weiterhin wird ein besonders einfacher Umbau der Vorrichtung bei unterschiedlichen Bauelementen und Strip-Geometrien ermöglicht. Die Anzahl der beim Umbau zu wechselnden Teile kann stark reduziert werden. Besonders vorteilhaft ist dabei, dass das Abdichtboard auch bei unterschiedlichen Bauelementen und Strip-geometrien identisch bleiben kann und - da die bauelementspezifische Anpassung bereits durch das innerhalb der Kavität angeordnete DUT-Board erfolgt - auch die außerhalb der Drucktestkammer an die Kontaktelemente anschließenden Einrichtungen, wie beispielsweise ein Interface-Board und/oder ein DIB-Board (Data Input Bus Board, d.h. Datenüberträgerboard), gleich bleiben können. Hierdurch können auch die Umbaukosten und die Umbauzeit verringert werden.

Gemäß einer vorteilhaften Ausführungsform bestehen zumindest die ersten Kontaktelementabschnitte aus in ihrer Längsrichtung federnden Kontaktstiften (Pogo-Pins). Es ist vorteilhaft, wenn auch die zweiten Kontaktelementabschnitte und gegebenenfalls auch die dritten Kontaktelementabschnitte aus derartigen federnden Kontaktstiften bestehen. Alternativ hierzu ist es jedoch auch denkbar, dass diejenigen Kontaktelementabschnitte, mit denen die Bauelemente in Kontakt bringbar sind, anders ausgebildet sind, beispielsweise die Form von geschwungenen Kontaktfedern haben.

Die Erfindung wird nachfolgend anhand der Zeichnungen näher erläutert. Es zeigen:
- Figur 1:: einen schematischen Vertikalschnitt durch eine Drucktestkammer, wie sie gemäß der Erfindung eingesetzt werden kann, zur Verdeutlichung der grundsätzlichen Funktionsweise der Drucktestkammer,
- Figur 2:: einen schematischen Längsschnitt durch eine Vorrichtung, die nicht Teil der Erfindung ist,
- Figur 3:: einen schematischen Längsschnitt durch eine erfindungsgemäße Vorrichtung, und
- Figur 4:: eine Explosionszeichnung von wesentlichen Teilen des Randbereichs der Vorrichtung von Figur 3.

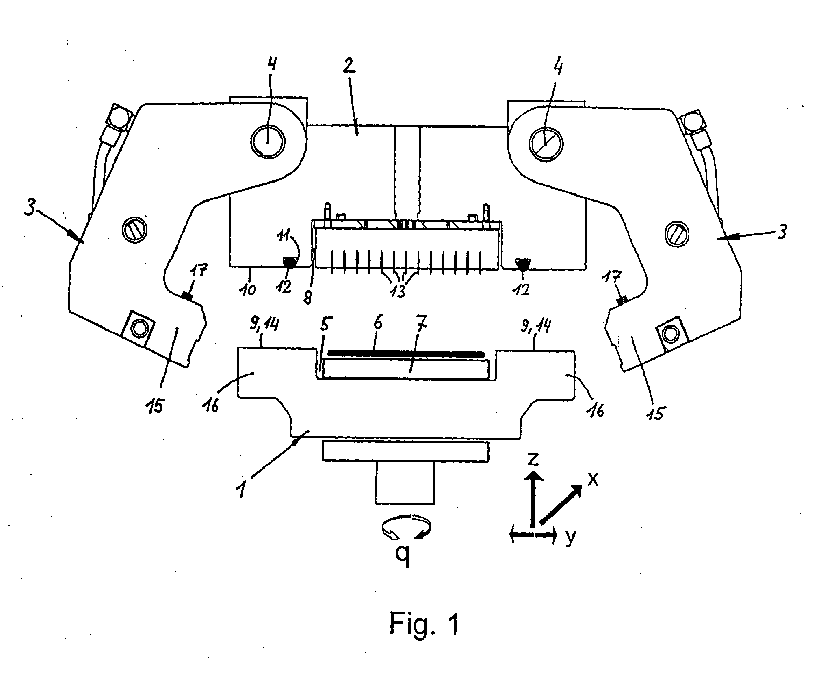

Aus Figur 1 ist eine Drucktestkammer mit einer ersten, unteren Druckkammerhälfte 1 und einer zweiten, oberen Druckkammerhälfte 2 ersichtlich. Im gezeigten Ausführungsbeispiel ist die obere Druckkammerhälfte 2 stationär angeordnet, während die untere Druckkammerhälfte 1 mittels einer nicht dargestellten Hebevorrichtung in vertikaler Richtung, d.h. in z-Richtung, angehoben bzw. abgesenkt werden kann.

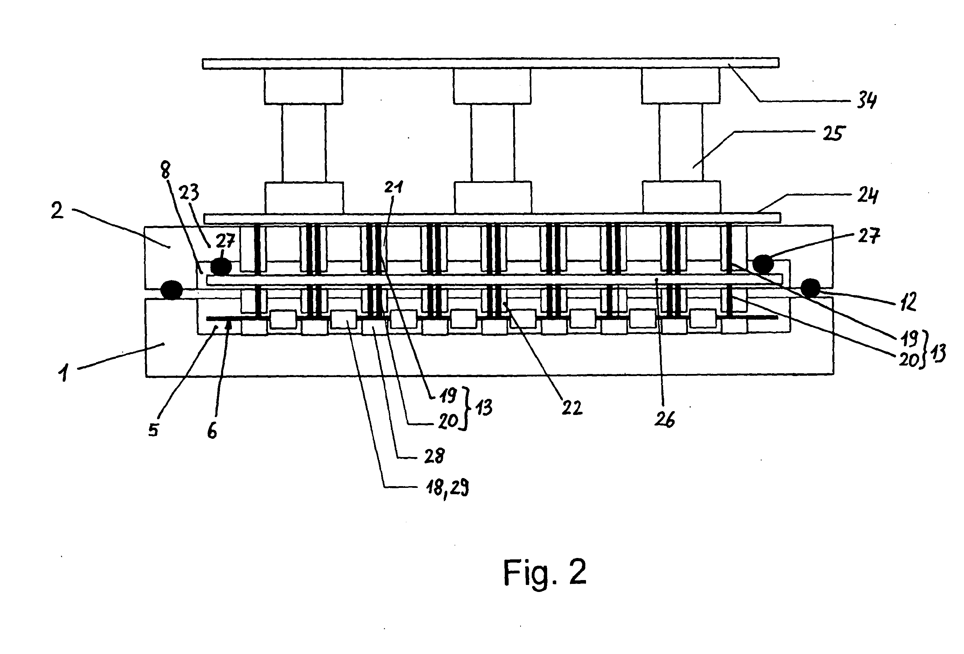

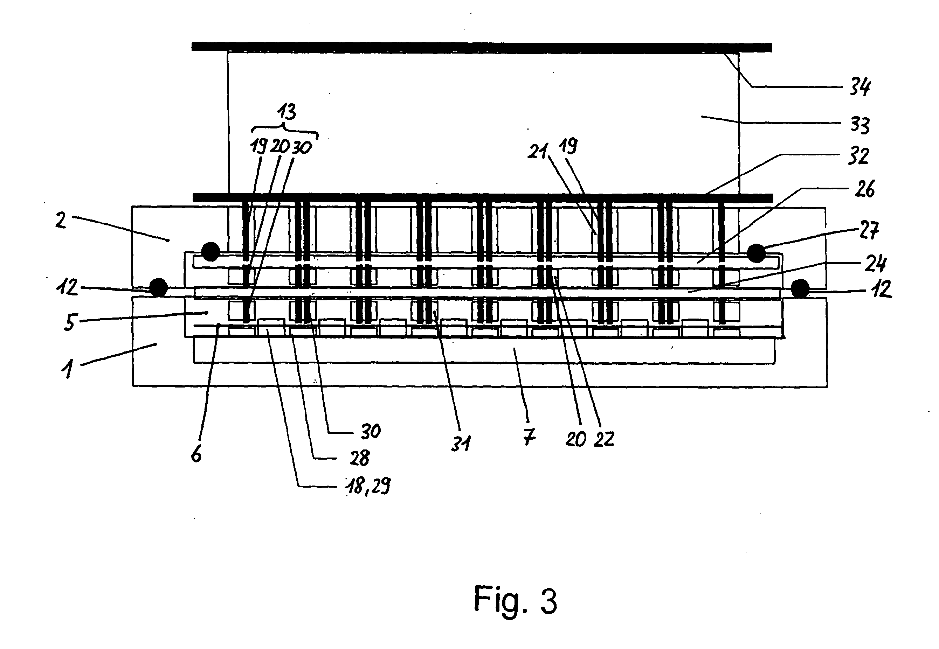

Weiterhin ist in Figur 1 ein zwei Schwenkbacken 3 umfassender Verschlussmechanismus ersichtlich. Die Schwenkbacken 3 sind um Schwenkachsen 4 zwischen einer in Figur 1 gezeigten Öffnungsstellung und einer in den Figuren 2 und 3 gezeigten Verschlussstellung schwenkbar. Die beiden Schwenkachsen 4 verlaufen parallel zueinander und können entweder - wie in Figur 1 dargestellt - an der oberen Druckkammerhälfte 2 gelagert sein oder alternativ auch oberhalb der Druckkammerhälfte 2.

Die beiden Druckkammerhälften 1, 2 haben in der Draufsicht zumindest im wesentlichen eine rechteckige Form. Die untere Druckkammerhälfte 1 weist eine Vertiefung 5 auf, in die mehrere nebeneinander angeordnete Bauelemente 18 (Figuren 2 bis 4) eingesetzt werden können, wenn sich die untere Druckkammerhälfte 1 in ausreichendem Abstand zur oberen Druckkammerhälfte 2 befindet. Im dargestellten Ausführungsbeispiel liegen die Bauelemente 18 nebeneinander in Form eines Verbunds vor, der als rechteckiger Strip 6 ausgebildet ist. Jeder Strip 6 kann sowohl in Längs- als auch in Querrichtung eine Mehrzahl von Bauelementen 18 aufweisen, die matrixförmig in der x-y-Ebene angeordnet sind.

Der Strip 6 kann auf ein Striptablett 7 (Figuren 1 und 3) aufgelegt und zusammen mit dem Striptablett 7 in die Vertiefung 5 der unteren Druckkammerhälfte 1 eingelegt werden. Es ist auch möglich, den Strip 6 ohne das Striptablett 7 in die Vertiefung 5 einzulegen, falls die untere Druckkammerhälfte 1 selbst eine entsprechende Auflageeinrichtung für den Strip 6 aufweist.

Die obere Druckkammerhälfte 2 weist eine Vertiefung 8 auf, die der Vertiefung 5 der unteren Druckkammerhälfte 1 gegenüberliegt und zusammen mit dieser eine geschlossene Kavität bildet, wenn die untere Druckkammerhälfte 1 an die obere Druckkammerhälfte 2 herangefahren wird.

Die Druckkammerhälften 1, 2 weisen einander zugewandte Flächen 9, 10 auf, die parallel zueinander und eben ausgebildet sind. In der Fläche 10 der oberen Druckkammerhälfte 2 ist eine um die Vertiefung 8 herumlaufende Nut 11 vorgesehen, in die eine Dichtung 12 in Form eines O-Rings eingebettet ist. Die Dichtung 12 steht nach unten über die Fläche 10 vor, so dass die Fläche 9 der unteren Druckkammerhälfte 1 gegen die Dichtung 12 gedrückt werden kann, wodurch die Kavität bei zusammengefahrenen Druckkammerhälften 1, 2 druckdicht verschlossen ist.

Von der oberen Druckkammerhälfte 2 stehen Kontaktelemente 13 in die Kavität hinein vor, die mit entsprechenden Kontakten der in die Vertiefung 5 eingelegten Bauelemente 18 in Kontakt gebracht werden können, wenn die beiden Druckkammerhälften 1, 2 zusammengefahren werden. Die Kontaktelemente 13 erstrecken sich, wie nachfolgend anhand der Figuren 2 bis 4 noch näher erläutert wird, durch die obere Druckkammerhälfte 2 hindurch in den Außenbereich der Drucktestkammer und sind mit einer nicht dargestellten elektronischen Testvorrichtung, zweckmäßiger Weise über einen Testkopf, verbunden.

Wie weiterhin in Figur 1 dargestellt ist, sind die beiden Schwenkbacken 3 C- oder U-förmig ausgebildet und weisen jeweils einen nach innen gerichteten Stützabschnitt 15 auf, der bei zusammengefahrenen Druckkammerhälften 1, 2 nach dem Zusammenschwenken der Schwenkachsen 3 einen Randabschnitt 16 der unteren Druckkammerhälfte 1 untergreift. Weiterhin weist jeder Schwenkbacken 3 mindestens eine nicht näher dargestellte Hubvorrichtung auf, die einen im Schwenkbacken 3 angeordneten Pneumatikzylinder umfasst, der über einen Hebelmechanismus auf einen Stößel 17 einwirkt. Der Stößel 17 ist längsverschiebbar im Stützabschnitt 15 gelagert und kann aus einer im wesentlichen zurückgezogenen Stellung, die in Figur 1 dargestellt ist, mittels des Kolbens nach oben über den Stützabschnitt 15 ausgefahren werden, so dass er bei geschlossenen Schwenkbacken 3 die untere Druckkammerhälfte 1 fest gegen die obere Druckkammerhälfte 2 bzw. gegen deren Dichtung 12 drückt, so dass die Kavität abgedichtet ist.

Weiterhin können die Schwenkbacken 3 eine nicht dargestellte mechanische Verriegelungseinrichtung aufweisen, mit der Abstandsplättchen in den Zwischenraum zwischen den Stützabschnitten 15 und den Randabschnitten 16 der unteren Druckkammerhälfte 1 eingeschoben werden können, nachdem der Stößel 17 die untere Druckkammerhälfte 1 gegen die Dichtung 12 der oberen Druckkammerhälfte 2 gedrückt hat. Hierdurch kann die dichte Anlage der unteren Druckkammerhälfte 1 an der oberen Druckkammerhälfte 2 auf mechanische Weise aufrechterhalten werden, so dass die Hubvorrichtungen entlastet werden können.

Zum Testen der Bauelemente 18 wird zunächst ein Strip 6, gegebenenfalls zusammen mit einem Striptablett 7, auf das der Strip 6 vorher ablegt wurde, in die Vertiefung 5 der unteren Druckkammerhälfte 1 eingelegt. Anschließend werden die Position des Strips 6 relativ zur unteren Druckkammerhälfte 6 sowie die Position der unteren Druckkammerhälfte 1 relativ zur oberen Druckkammerhälfte 2 (mittels eines bekannten Verfahrens) ermittelt.

Die untere Druckkammerhälfte 1 wird mittels der nicht dargestellten Hebevorrichtung in z-Richtung bis in unmittelbare Nähe der oberen Druckkammerhälfte hochgefahren, wobei die untere Druckkammerhälfte 1 in einer genauen Testposition relativ zur oberen Druckkammerhälfte 2 positioniert wird.

Anschließend werden die beiden Schwenkbacken 3 nach innen geschwenkt, wobei die Stützabschnitte 15 die Randabschnitte 16 der unteren Druckkammerhälfte 1 untergreifen. In dieser Stellung werden die Stößel 17 nach oben ausgefahren, so dass die untere Druckkammerhälfte 1 gegen die Dichtung der oberen Druckkammerhälfte 2 gedrückt wird, und sich diese Dichtung 12 entsprechend elastisch verformt. Anschließend werden die nicht dargestellten Abstandsplättchen mittels der mechanischen Verriegelungseinrichtung in den Zwischenraum zwischen den Stützabschnitten 15 der Schwenkbacken 3 und der unteren Druckkammerhälfte 1 eingefahren. Die Stößel 17 können nun zurückgefahren werden, wobei die dichte Anlage der unteren Druckkammerhälfte 1 an der Dichtung 12 aufrechterhalten bleibt. In dieser Stellung sind die Kontakte der Bauelemente 18 mit den Kontaktelementen 13 der oberen Druckkammerhälfte 2 kontaktiert.

Anschließend wird in der Kavität der gewünschte Testdruck aufgebaut. Ist dieser Testdruck erreicht, wird die elektronische Messung der Bauelemente 18 durchgeführt.

Nach Ende der Messung wird der Druck in der Kavität abgebaut. Es werden die Stößel 17 kurzzeitig ausgefahren, um die Abstandsplättchen zurückziehen zu können. Dann werden die Stößel 17 wieder in die Stützabschnitte 15 zurückgezogen. Die Schwenkbacken 3 können nun wieder in die in Figur 1 gezeigte geöffnete Stellung hochgeschwenkt werden, worauf die untere Druckkammerhälfte 1 nach unten von der oberen Druckkammerhälfte weggefahren wird, so dass die getesteten Bauelemente 18, gegebenenfalls mit dem Striptablett 7, aus der unteren Druckkammerhälfte 1 entnommen werden können. Die Drucktestkammer kann damit wieder mit neuen Bauelementen 18 beladen werden.

Die untere Druckkammerhälfte 1 kann relativ zur oberen Druckkammerhälfte 2 in x- und/oder y-Richtung verschiebbar und/oder um die z-Achse drehbar sein, so dass die Anzahl der Kontaktelemente 13 niedriger als diejenige der Kontakte der in die Kavität eingelegten Bauelemente 18 sein kann. In diesem Fall wird zunächst nur ein Teil der eingelegten Bauelemente 18 kontaktiert und getestet, dann die untere Druckkammerhälfte 1 verschoben und/oder gedreht und anschließend ein weiterer Teil der eingelegten Bauelemente 18 kontaktiert und getestet. Dieser Vorgang wird so oft wiederholt, bis sämtliche eingelegten Bauelemente 18 kontaktiert und getestet worden sind. Erst anschließend wird die Druckkammerhälfte 1 soweit abgesenkt, dass die getesteten Bauelemente 18 entnommen und neue Bauelemente 18 eingelegt werden können. Diese Art des schrittweisen Testens bei seitlichem Verschieben und/oder Verdrehen der unteren Druckkammerhälfte 1 ist im Rahmen der vorliegenden Erfindung jedoch lediglich optional.

Anhand von Figur 2 wird nachfolgend eine nicht erfindungsgemäße Vorrichtung näher erläutert. Bei dieser Vorrichtung besteht jedes Kontaktelement 13 aus einem ersten Kontaktelementabschnitt 19 und einem hierzu beabstandeten, zweckmäßigerweise fluchtenden zweiten Kontaktelementabschnitt 20. Die Kontaktelementabschnitte 19, 20 bestehen im dargestellten Ausführungsbeispiel jeweils aus federnden Kontaktstiften (Pogo pins), wobei eine Mehrzahl benachbarter Kontaktstifte in Form von sogenannten Pogo stacks 21, 22 gebündelt vorliegen können. Die ersten Kontaktelementabschnitte 19 bzw. Pogo stacks 21 durchdringen die obere Wand 23 der oberen Druckkammerhälfte 2. Die äußeren Enden der ersten Kontaktelementabschnitte 19 stehen mit zugeordneten Kontakten eines DUT-Boards 24 (Device Under Test Board) in elektrischem Kontakt, das oberhalb der oberen Druckkammerhälfte 2 und damit außerhalb der Drucktestkammer angeordnet ist. Beim DUT-Board 24 handelt es sich um eine bauelementspezifische, wechselbare Platine. Das DUT-Board 24 ist über elektrische Verbindungselemente 25 mit einem DIB-Board (Data Input Bus Board) in Verbindung, über das eine elektrische Verbindung zur (nicht dargestellten) elektronischen Testvorrichtung geschaffen wird.

Die inneren Enden der ersten Kontaktelementabschnitte 19, die sich geringfügig über die Unterseite der oberen Wand 23 hinaus nach innen erstrecken, sind mit zugeordneten Kontakten auf der Oberseite eines Abdichtboards 26 in Kontakt. Das Abdichtboard 26 ist als luftdichte Platte oder Platine ausgebildet, die sich quer zur Längserstreckung der Kontaktelemente 13 über sämtliche Kontaktelemente 13 erstreckt und die ersten Kontaktelementabschnitte 19 von den zweiten Kontaktelementabschnitten 20 räumlich trennt. Das Abdichtboard 26 ist an der Wand 23 der oberen Druckkammerhälfte 2 befestigt und in ihrem Randbereich mittels einer umlaufenden Dichtung 27 gegenüber der Wand 23 luftdicht abgedichtet. Das Abdichtboard 26 verhindert somit, dass Luft oder ein anderes Gas aus dem Kavitätsbereich, in dem der Testdruck (mittels nicht dargestellter Leitungen) aufgebaut wird, über die Öffnungen in der Wand 23, in denen die ersten Kontaktelementabschnitte 19 oder Pogo stacks 21 angeordnet sind, nach außen (oder nach innen) gelangen kann.

Das Abdichtboard 26 weist an seiner Unterseite elektrische Kontakte auf, die den Kontakten auf seiner Oberseite entsprechen und mit diesem elektrisch verbunden sind. An diesen unterseitigen Kontakten liegen die oberen Enden der zweiten Kontaktelementabschnitte 20 an, so dass diese mit den jeweiligen zugeordneten ersten Kontaktelementabschnitten 19 elektrisch verbunden sind.

Zweckmäßigerweise befinden sich die zweiten Kontaktelementabschnitte 20 oder Pogo stacks 22 in Kontaktsockeln, die von unten her am Abdichtboard 26 befestigt werden. Die unteren Enden der zweiten Kontaktelementabschnitte 20 sind dabei entsprechend den Kontakten der zu testenden Bauelemente 18 angeordnet, so dass die Bauelementkontakte mit den zweiten Kontaktelementabschnitten 20 kontaktiert werden können, wenn die untere Druckkammerhälfte 1 in dichte Anlage gegen die obere Druckkammerhälfte 2 gedrückt wird. Die Dichtung 12 verhindert dabei, dass Luft zwischen den Druckkammerhälften 1, 2 aus der Kavität nach außen oder umgekehrt von außen in die Kavität gelangen kann, wie dies anhand von Figur 1 beschrieben wurde.

In der Vorrichtung von Figur 2 wird der Strip 6 auf eine Mehrzahl von Stützelementen 28 (Lead backers) aufgelegt, die sich am Boden der Vertiefung 5 befinden und den Strip 6 im Bereich der Bauelementkontakte unterstützen. Der Bauelementkörper 29 ist dabei zwischen Stützelementen 28 angeordnet.

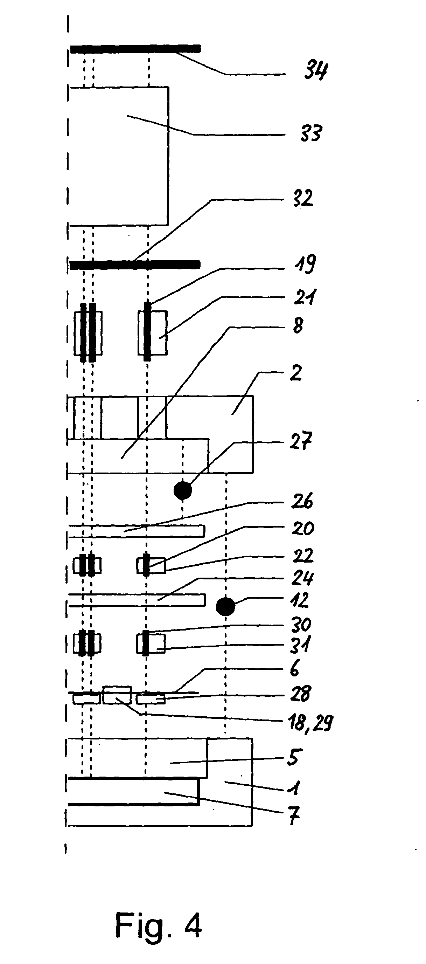

Anhand der Figuren 3 und 4 wird nachfolgend eine Ausführungsform der erfindungsgemäßen Vorrichtung näher beschrieben. Diese Ausführungsform unterscheidet sich von der vorstehend beschriebenen Vorrichtung im Wesentlichen dadurch, dass das DUT-Board 24 nicht außerhalb, sondern innerhalb der Kavität der Drucktestkammer angeordnet ist und sich zwischen dem Abdichtboard 26 und den zu testenden Bauelementen 18 befindet. Die beiden Druckkammerhälften 1, 2, ihre gegenseitige Abdichtung mittels der Dichtung 12, die ersten Kontaktelementabschnitte 19 bzw. Pogo stacks 21 und deren Abdichtung mittels des Abdichtboards 26 sowie die Dichtung 27 sind gleich oder ganz ähnlich wie bei der in Figur 2 dargestellten Vorrichtung ausgebildet und angeordnet, so dass diesbezüglich auf die dortige Vorrichtung verwiesen wird.

Wie aus den Figuren 3 und 4 ersichtlich, ist das DUT-Board 24 parallel zum Abdichtboard 26, d.h. im vorliegenden Ausführungsbeispiel horizontal, zwischen den unteren Enden der zweiten Kontaktelementabschnitte 20 und zugeordneten dritten Kontaktelementabschnitten 30 angeordnet. Die dritten Kontaktelementabschnitte 30 bestehen wiederum aus federnden Kontaktstiften (Pogo pins), die entsprechend den Kontakten der zu kontaktierenden Bauelemente 18 angeordnet sind, so dass die Bauelementkontakte mit den dritten Kontaktelementabschnitten 30 kontaktiert werden können, wenn die untere Druckkammerhälfte 1 in dichte Anlage gegen die obere Druckkammerhälfte 2 gedrückt wird.

Die dritten Kontaktelementabschnitte 30 können wiederum gebündelt in Form von Pogo stacks 31 vorliegen und sind mittels Kontaktsockeln an der Unterseite des DUT-Boards 24 befestigt.

Das auswechselbare, bauelementspezifische DUT-Board 24 dient bei dieser Ausführungsform dazu, die dritten Kontaktelementabschnitte 30 zu den zweiten Kontaktelementabschnitten 20 durchzukontaktieren und dabei die bauelementspezifisch angeordneten und ausgebildeten dritten Kontaktelementabschnitte 30 mit den zugeordneten zweiten Kontaktelementabschnitten 20 zu kontaktieren, die nicht bauelementspezifisch angeordnet und/oder ausgebildet sein müssen. Diese Ausführungsform bietet somit den Vorteil, dass bei einem Wechsel der zu testenden Bauelementtypen lediglich das DUT-Board 24 und die dritten Kontaktelementabschnitte 30 auf der Seite der oberen Druckkammerhälfte 2 ausgetauscht werden müssen, während die oberhalb des DUT-Boards 24 angeordneten Komponenten universell einsetzbar sind, d.h. für unterschiedliche Bauelementtypen geeignet sind.

Der Strip 6 liegt im Bereich der Bauelementkontakte auf Stützelementen 28 (Lead backers) auf, die auf einem in die Vertiefung 5 einsetzbaren Striptablett 7 angeordnet sind.

Die oberen Enden der ersten Kontaktelementabschnitte 19 sind mit einem universellen Schnittstellen-Board 32 in Kontakt, das oberhalb der oberen Druckkammerhälfte 2 und damit außerhalb der Drucktestkammer angeordnet ist. Dieses Schnittstellen-Board 32 steht wiederum über ein universelles Durchstoß-Board 33 (Through-Board) mit einem DIB-Board 34 (Data Input Bus Board) in Kontakt. Auch das Schnittstellen-Board, Durchstoß-Board 33 und DIB-Board 34 sind somit gleichermaßen zum Testen von unterschieden Bauelementtypen geeignet.

## Patentansprüche

1. Vorrichtung zum Testen von elektronischen Bauelementen, insbesondere IC's, unter bestimmten Druckbedingungen, mit folgenden Merkmalen:
- die Vorrichtung weist ein bauelementspezifisches DUT-Board (24) und eine teilbare Drucktestkammer mit zwei voneinander trennbaren und zusammenfahrbaren Druckkammerhälften (1, 2) auf, die zueinander in eine Kontaktposition bringbar sind, in der sie eine Kavität dicht umschließen,
- die Drucktestkammer weist Kontaktelemente (13) auf, welche sich in die Kavität hinein erstrecken, derart, dass Kontakte von zu testenden und in der Kavität angeordneten Bauelementen (18) mit zugeordneten Kontaktelementen (13) in Kontakt bringbar sind,
- die Kontaktelemente (13) erstrecken sich durch eine der Druckkammerhälften (1, 2) hindurch und sind mit einer elektronischen Testvorrichtung in elektrischem Kontakt, wobei jedes Kontaktelement (13) in einen die Druckkammerhälfte (2) durchdringenden ersten Kontaktelementabschnitt (19) und einen zum ersten Kontaktelementabschnitt (19) beabstandeten zweiten Kontaktelementabschnitt (20) unterteilt ist, der innerhalb der Kavität angeordnet ist, wobei
innerhalb der Kavität ein luftundurchlässiges Abdichtboard (26) angeordnet ist, das sich quer über die Kontaktelemente (13) erstreckt und randseitig zur zugeordneten Druckkammerhälfte (2) hin abgedichtet ist, wobei die ersten Kontaktelementabschnitte (19) auf einer Seite des Abdichtboards (26) und die den ersten Kontaktelementabschnitten (19) gegenüberliegenden zweiten Kontaktelementabschnitte (20) auf der gegenüberliegenden Seite des Abdichtboards (26) angeordnet sind und die ersten Kontaktelementabschnitte (19) mit den gegenüberliegenden zweiten Kontaktelementabschnitten (20) über leitende Abschnitte des Abdichtboards (26) elektrisch verbunden sind, **dadurch gekennzeichnet dass** das bauelementspezifische DUT-Board (24) innerhalb der Kavität zwischen den zweiten Kontaktelementabschnitten (19) und zu den zweiten Kontaktelementabschnitten (19) beabstandeten dritten Kontaktelementabschnitten (30) angeordnet ist, mit denen die Kontakte der Bauelemente (18) in Kontakt bringbar sind.

2. Vorrichtung nach Anspruch 1, **dadurch gekennzeichnet, dass** zumindest die ersten Kontaktelementabschnitte (19) aus in ihrer Längsrichtung federnden Kontaktstiften bestehen.

3. Vorrichtung nach einem Anspruch 1 oder 2, **dadurch gekennzeichnet, dass** die dritten Kontaktelementabschnitte (30) aus in ihrer Längsrichtung federnden Kontaktstiften bestehen.

## Claims

1. A device for testing electronic components, in particular ICs, under specific pressure conditions, having the following features:
- the device has a component-specific DUT board (24) and a separable pressure testing chamber with two pressure chamber halves (1, 2) which can be separated from each other and moved together and can be brought towards each other into a contact position, in which they enclose a cavity in a leak-tight manner,
- the pressure testing chamber has contact elements (13) which extend into the cavity in such a manner that contacts of components (18) which are to be tested and are arranged in the cavity can be brought into contact with associated contact elements (13),
- the contact elements (13) extend through one of the pressure chamber halves (1, 2) and are in electrical contact with an electronic testing device, wherein each contact element (13) is divided into a first contact element section (19) which penetrates the pressure chamber half (2) and a second contact element section (20) which is spaced apart from the first contact element section (19) and is arranged inside the cavity,
wherein an air-impermeable sealing board (26) is arranged inside the cavity, which board extends transversely across the contact elements (13) and is sealed off at the edges towards the associated pressure chamber half (2), wherein the first contact element sections (19) are arranged on one side of the sealing board (26) and the second contact element sections (20) opposite the first contact element sections (19) are arranged on the opposite side of the sealing board (26), and the first contact element sections (19) are electrically connected to the opposite second contact element sections (20) via conductive sections of the sealing board (26), **characterised in that** the component-specific DUT board (24) is arranged inside the cavity between the second contact element sections (19) and third contact element sections (30) which are spaced apart from the second contact element sections (19) and with which the contacts of the components (18) can be brought into contact.

2. The device according to Claim 1, **characterised in that** at least the first contact element sections (19) consist of contact pins which are resilient in the longitudinal direction thereof.

3. The device according to Claim 1 or 2, **characterised in that** the third contact element sections (30) consist of contact pins which are resilient in the longitudinal direction thereof.

## Revendications

1. Dispositif pour tester des composants électroniques, en particulier des circuits intégrés (IC), sous certaines conditions de pression, comprenant les particularités suivantes :
- le dispositif comprend une carte spécifique aux composants (24) dite carte "DUT" (Device Under Test) et une chambre de test sous pression susceptible d'être divisée avec deux moitiés de chambre sous pression (1, 2) susceptibles d'être séparées l'une de l'autre et d'être regroupées, qui peuvent être amenées l'une vers l'autre jusque dans une position de contact dans laquelle elles enferment de manière étanche une cavité,
- la chambre de test sous pression comprend des éléments de contact (13) qui s'étendent jusque dans l'intérieur de la cavité de telle façon que des contacts appartenant à des composants (18) à tester et placés dans la cavité peuvent être amenés en contact avec des éléments de contact (13) associés,
- les éléments de contact (13) s'étendent à travers l'une des moitiés de chambre sous pression (1, 2) et sont en contact électrique avec un dispositif de test électronique, tels que chaque élément de contact (13) est subdivisé en un premier tronçon d'élément de contact (19) qui traverse la moitié de chambre sous pression (2) et en un second tronçon d'élément de contact (20), à distance du premier tronçon d'élément de contact (19), qui est agencé à l'intérieur de la cavité,
dans lequel
à l'intérieur de la cavité est agencée une carte d'étanchement (26) imperméable à l'air, qui s'étend transversalement au-dessus des éléments de contact (13) et qui est étanchée du côté de sa bordure vis-à-vis de la moitié de chambre sous pression (2) associée, dans lequel les premiers tronçons d'éléments de contact (19) sont agencés sur un côté de la carte d'étanchement (26) et les seconds tronçons d'éléments de contact (20) opposés aux premiers tronçons d'éléments de contact (19) sont agencés sur le côté opposé de la carte d'étanchement (26) et les premiers tronçons d'éléments de contact (19) sont reliés électriquement aux seconds tronçons d'éléments de contact (20) opposés via des portions conductrices de la carte d'étanchement (26),
**caractérisé en ce que** la carte DUT spécifique aux composants (24) est agencée à l'intérieur de la cavité entre les seconds tronçons d'éléments de contact (19) et des troisièmes tronçons d'éléments de contact (30) à distance des seconds tronçons d'éléments de contact (19), avec lesquels les contacts des composants (18) peuvent être amenés en contact.

2. Dispositif selon la revendication 1, **caractérisé en ce que** les premiers tronçons d'éléments de contact (19) au moins sont constitués par des tiges de contact à effet ressort dans leur direction longitudinale.

3. Dispositif selon l'une des revendications 1 ou 2, **caractérisé en ce que** les troisièmes tronçons d'éléments de contact (30) sont constitués par des tiges de contact à effet ressort dans leur direction longitudinale.
